# EUROPEAN PATENT SPECIFICATION

(11) **EP 4 589 637 B1**
(45) Date of publication and mention of the grant of the patent: **23.09.2026**
(21) Application number: 25150569.9
(22) Date of filing: 07.01.2025
(51) Int. Cl.: H10W 70/05, H10W 70/60, H10W 70/62, H03K 17/81, H10W 70/65, H10W 90/00

(54) **DIE ROTATION SETUP WITH REDUCED SERDES TRACE ROUTE LENGTHS**
MATRIZENROTATIONSEINRICHTUNG MIT REDUZIERTEN SERDES-TRACE-ROUTENLÄNGEN
CONFIGURATION DE ROTATION DE MATRICE AVEC DES LONGUEURS RÉDUITES DE TRACE DE SERDES

(30) Priority: 19.01.2024 US 202418418149
(43) Date of publication of application: 23.07.2025
(73) Proprietor: Cisco Technology, Inc., San Jose, CA 95134-1706 (US)
(72) Inventor: MENG, Jiayou, Shanghai (CN)
(74) Representative: Mathys & Squire

(56) References cited:
- US-A1- 2020 265 002
- US-B1- 10 043 724

## Description

The present disclosure relates to processing units. More particularly, the present disclosure relates to configuring a processing unit to utilize a die in multiple rotational states with reduced trace routes for various channels.

### BACKGROUND

ASIC, or Application-Specific Integrated Circuits, represent a type of integrated circuit tailored for a specific application rather than serving as a general-purpose device. The process of ASIC design involves several stages, including specification, design, verification, and manufacturing. Designers utilize hardware description languages (HDLs) such as Verilog or VHDL to articulate the functionality of the circuit. The key feature of ASICs is their customization for a particular purpose, allowing for optimization in performance, power efficiency, and physical size. This customization contributes to the superior performance of ASICs compared to general-purpose processors, as they are engineered to excel in their designated functions.

While ASICs offer enhanced performance, their development often incurs higher upfront costs for design and manufacturing. This cost is justified in applications where specific performance, power efficiency, or other tailored requirements are crucial. Despite the advantages, ASIC development typically takes longer compared to utilizing off-the-shelf components. Once developed, however, ASICs prove advantageous in terms of their specialized performance and efficiency. Examples of ASIC applications span diverse fields, including telecommunications, automotive systems, consumer electronics, and notably in cryptocurrency, where ASICs are commonly employed for mining purposes, optimized for specific hashing algorithms.

For certain processing units, ASIC chip family planning often comprises a first version that is fully functional (and includes full serialization/deserialization (SerDes) functionality. However, at the second phase, for the cost sensitive products, designs can be a configured as a "lite" version to keep costs down. These configurations can use the same die but reduce the SerDes channel numbers to half or less than half with smaller packages. This can lead to inefficient usage of the available dies.

US 10 043 724 discloses an integrated circuit die. die, and US 2020/265002 A1 discloses a die that can be rotate and attached to a substrate in two orientations.

### SUMMARY OF THE DISCLOSURE

Systems and methods for configuring a processing unit to utilize a die in multiple rotational states with reduced trace routes for various channels in accordance with embodiments of the disclosure are described herein.

Aspects of the invention are set out in the independent claims and preferred features are set out in the dependent claims. Features of one aspect may be applied to each aspect alone or in combination with other features.

In the invention, a processing unit includes a die, wherein the die is bifurcated, and a substrate, configured to couple with the die at a first orientation, wherein the substrate is further configured to couple with the die at a second orientation.

In some embodiments, the second orientation is one-hundred and eighty degrees relative to the first orientation.

In some embodiments, the bifurcation is configured to render the die into a first slice and a second slice.

In the invention, the first slice and second slice have similar communication channels.

In some embodiments, the communication channels include a plurality of serialization/deserialization (SerDes) channels.

In some embodiments, the plurality of SerDes channels are divided equally between the first slice and the second slice.

In some embodiments, the substrate is configured with a plurality of corresponding SerDes channels.

In some embodiments, the substrate extends outward from the die on all four sides when coupled.

In some embodiments, the plurality of corresponding SerDes channels on the substrate are disposed on three of the four sides.

In some embodiments, the corresponding SerDes channels are communicatively coupled to the plurality of SerDes channels on the substrate through a matching plurality of traces.

In some embodiments, the corresponding plurality of SerDes channels on the substrate are arranged to facilitate shorter trace lengths of the matching plurality of traces.

In some embodiments, a method includes bifurcating a die into a first slice and a second slice, configuring a substrate to couple with the die at both a first orientation associated with a first slice, and a second orientation associated with the second slice, and coupling the die to the substrate.

In some embodiments, each slice of the die is configured with a plurality of serialization/deserialization (SerDes) channels.

In some embodiments, the substrate is further configured with a corresponding plurality of SerDes channels.

In some embodiments, the substrate extends outward from the die on all four sides when coupled.

In some embodiments, the plurality of corresponding SerDes channels on the substrate are disposed on three of the four sides.

In some embodiments, the corresponding SerDes channels are communicatively coupled to the plurality of SerDes channels on the substrate through a matching plurality of traces.

**In** some embodiments, the corresponding plurality of SerDes channels on the substrate are arranged to facilitate shorter trace lengths of the matching plurality of traces.

**In** some embodiments, a processing unit includes a die, wherein the die is bifurcated into a first slice and a second slice, and configured with a plurality of similar serialization/deserialization (SerDes) channels on each slice, and a substrate, wherein the substrate is configured to communicatively couple with the plurality of SerDes channels via a corresponding plurality of SerDes channels and a matching plurality of traces, and wherein, the substrate is further configured to couple with the die in at least two orientations. Each orientation providing similar communicative coupling between the plurality of SerDes channels on each slice and the corresponding SerDes channels and matching plurality of traces on the substrate.

Other objects, advantages, novel features, and further scope of applicability of the present disclosure will be set forth in part in the detailed description to follow, and in part will become apparent to those skilled in the art upon examination of the following or may be learned by practice of the disclosure. Although the description above contains many specificities, these should not be construed as limiting the scope of the disclosure but as merely providing illustrations of some of the presently preferred embodiments of the disclosure. As such, various other embodiments are possible within its scope. Accordingly, the scope of the disclosure should be determined not by the embodiments illustrated, but by the appended claims and their equivalents.

### BRIEF DESCRIPTION OF DRAWINGS

The above, and other, aspects, features, and advantages of several embodiments of the present disclosure will be more apparent from the following description as presented in conjunction with the following several figures of the drawings.
FIG. 1 is a conceptual partial cutaway illustration of a processor in accordance with various embodiments of the disclosure;
FIG. 2 is a conceptual partial cutaway illustration of a processing unit in accordance with various embodiments of the disclosure;
FIG. 3 is a conceptual side-view illustration of a processing package in accordance with various embodiments of the disclosure;
FIG. 4 is a conceptual illustration of a bifurcated die with two slices in accordance with various embodiments of the disclosure;
FIG. 5 is a conceptual illustration of a rotatable die coupled with a substrate in a south slice rotation in accordance with various embodiments of the disclosure;
FIG. 6 is a conceptual illustration of a rotatable die coupled with a substrate in a north slice rotation in accordance with various embodiments of the disclosure;
FIG. 7 is a flowchart depicting a process for coupling a bifurcated die in a substrate in multiple orientations in accordance with various embodiments of the disclosure; and
FIG. 8 is a flowchart depicting a process for configuring a substrate for use with a bifurcated die in accordance with various embodiments of the disclosure.

Corresponding reference characters indicate corresponding components throughout the several figures of the drawings. Elements in the several figures are illustrated for simplicity and clarity and have not necessarily been drawn to scale. For example, the dimensions of some of the elements in the figures might be emphasized relative to other elements for facilitating understanding of the various presently disclosed embodiments. In addition, common, but well-understood, elements that are useful or necessary in a commercially feasible embodiment are often not depicted in order to facilitate a less obstructed view of these various embodiments of the present disclosure.

### DETAILED DESCRIPTION

In response to the issues described above, devices and methods are discussed herein that can enter deep standby lower-power state utilizing a physical level connection while retaining connections with neighboring devices, thus conserving a greater amount of electricity. A processor package is a sophisticated assembly comprising various components that collectively house and facilitate the operation of the central processing unit (CPU). At the heart of the package lies the die, a tiny silicon chip containing the processor's core elements, such as the arithmetic and logic units and cache memory. This die is mounted on a substrate, often made of materials like fiberglass-reinforced epoxy, providing structural support and hosting a network of trace routes. These trace routes serve as electrical pathways, enabling communication between the die and other parts of the package, as well as the external components on the motherboard.

The substrate, besides offering mechanical support, features a package cavity, a recessed area where the die is securely positioned. This cavity not only protects the delicate die but also accommodates thermal solutions, like heat spreaders or heat sinks, crucial for managing the heat generated during processor operation. The package is externally connected to the motherboard through package pins, arranged in a grid pattern along the edges, which transmit signals, power, and ground connections.

Additionally, the processor package incorporates a lid or cap, often referred to as the Integrated Heat Spreader (IHS). This metal cover sits atop the die and aids in dissipating heat away from the processor. To enhance thermal conductivity, a Thermal Interface Material (TIM) is applied between the die and the IHS. The efficient transfer of heat is pivotal in maintaining optimal operating temperatures and ensuring the processor's reliability.

The overall package is designed to be mounted on the motherboard using either a Ball Grid Array (BGA) or Land Grid Array (LGA) configuration. In the BGA setup, the processor is directly soldered to the motherboard, while in the LGA arrangement, an array of lands on the motherboard makes contact with corresponding pins on the processor package. The intricate interplay of these components, including the die, substrate, trace routes, thermal solutions, and external connections, is fundamental in creating a high-performance and reliable processor package for modern computing systems.

ASIC, or Application-Specific Integrated Circuits, represent a type of processor tailored for a specific application rather than serving as a general-purpose device. The process of ASIC design involves several stages, including specification, design, verification, and manufacturing. Designers utilize hardware description languages (HDLs) such as Verilog or VHDL to articulate the functionality of the circuit. The key feature of ASICs is their customization for a particular purpose, allowing for optimization in performance, power efficiency, and physical size. This customization contributes to the superior performance of ASICs compared to general-purpose processors, as they are engineered to excel in their designated functions.

While ASICs offer enhanced performance, their development often incurs higher upfront costs for design and manufacturing. This cost is justified in applications where specific performance, power efficiency, or other tailored requirements are crucial. Despite the advantages, ASIC development typically takes longer compared to utilizing off-the-shelf components. Once developed, however, ASICs prove advantageous in terms of their specialized performance and efficiency. Examples of ASIC applications span diverse fields, including telecommunications, automotive systems, consumer electronics, and notably in cryptocurrency, where ASICs are commonly employed for mining purposes, optimized for specific hashing algorithms.

For certain processing units, ASIC chip design planning often comprises a first version that is fully functional (and includes full serialization/deserialization (SerDes) functionality. However, at the second phase, for the cost sensitive products, designs can be a configured as a "lite" version to keep costs down. These configurations can use the same die but reduce the SerDes channel numbers to half or less than half with smaller packages. This can lead to inefficient usage of the available dies. Therefore, embodiments described herein can more efficiently compress the SerDes and other communication channels by configuring the die in a bifurcated manner and couple it with a substrate that is configured with a compressed SerDes channel design, allow for reduced trace lengths which can increase performance and potentially reduce manufacturing costs.

Aspects of the present disclosure may be embodied as an apparatus, system, method, or computer program product. Accordingly, aspects of the present disclosure may take the form of an entirely hardware embodiment, an entirely software embodiment (including firmware, resident software, micro-code, or the like) or an embodiment combining software and hardware aspects that may all generally be referred to herein as a "function," "module," "apparatus," or "system." Furthermore, aspects of the present disclosure may take the form of a computer program product embodied in one or more non-transitory computer-readable storage media storing computer-readable and/or executable program code. Many of the functional units described in this specification have been labeled as functions, in order to emphasize their implementation independence more particularly. For example, a function may be implemented as a hardware circuit comprising custom VLSI circuits or gate arrays, off-the-shelf semiconductors such as logic chips, transistors, or other discrete components. A function may also be implemented in programmable hardware devices such as via field programmable gate arrays, programmable array logic, programmable logic devices, or the like.

Functions may also be implemented at least partially in software for execution by various types of processors. An identified function of executable code may, for instance, comprise one or more physical or logical blocks of computer instructions that may, for instance, be organized as an object, procedure, or function. Nevertheless, the executables of an identified function need not be physically located together but may comprise disparate instructions stored in different locations which, when joined logically together, comprise the function and achieve the stated purpose for the function.

Indeed, a function of executable code may include a single instruction, or many instructions, and may even be distributed over several different code segments, among different programs, across several storage devices, or the like. Where a function or portions of a function are implemented in software, the software portions may be stored on one or more computer-readable and/or executable storage media. Any combination of one or more computer-readable storage media may be utilized. A computer-readable storage medium may include, for example, but not limited to, an electronic, magnetic, optical, electromagnetic, infrared, or semiconductor system, apparatus, or device, or any suitable combination of the foregoing, but would not include propagating signals. In the context of this document, a computer readable and/or executable storage medium may be any tangible and/or non-transitory medium that may contain or store a program for use by or in connection with an instruction execution system, apparatus, processor, or device.

Computer program code for carrying out operations for aspects of the present disclosure may be written in any combination of one or more programming languages, including an object-oriented programming language such as Python, Java, Smalltalk, C++, C#, Objective C, or the like, conventional procedural programming languages, such as the "C" programming language, scripting programming languages, and/or other similar programming languages. The program code may execute partly or entirely on one or more of a user's computer and/or on a remote computer or server over a data network or the like.

A component, as used herein, comprises a tangible, physical, non-transitory device. For example, a component may be implemented as a hardware logic circuit comprising custom VLSI circuits, gate arrays, or other integrated circuits; off-the-shelf semiconductors such as logic chips, transistors, or other discrete devices; and/or other mechanical or electrical devices. A component may also be implemented in programmable hardware devices such as field programmable gate arrays, programmable array logic, programmable logic devices, or the like. A component may comprise one or more silicon integrated circuit devices (e.g., chips, die, die planes, packages) or other discrete electrical devices, in electrical communication with one or more other components through electrical lines of a printed circuit board (PCB) or the like. Each of the functions and/or modules described herein, in certain embodiments, may alternatively be embodied by or implemented as a component.

A circuit, as used herein, comprises a set of one or more electrical and/or electronic components providing one or more pathways for electrical current. In certain embodiments, a circuit may include a return pathway for electrical current, so that the circuit is a closed loop. In another embodiment, however, a set of components that does not include a return pathway for electrical current may be referred to as a circuit (e.g., an open loop). For example, an integrated circuit may be referred to as a circuit regardless of whether the integrated circuit is coupled to ground (as a return pathway for electrical current) or not. In various embodiments, a circuit may include a portion of an integrated circuit, an integrated circuit, a set of integrated circuits, a set of non-integrated electrical and/or electrical components with or without integrated circuit devices, or the like. In one embodiment, a circuit may include custom VLSI circuits, gate arrays, logic circuits, or other integrated circuits; off-the-shelf semiconductors such as logic chips, transistors, or other discrete devices; and/or other mechanical or electrical devices. A circuit may also be implemented as a synthesized circuit in a programmable hardware device such as field programmable gate array, programmable array logic, programmable logic device, or the like (e.g., as firmware, a netlist, or the like). A circuit may comprise one or more silicon integrated circuit devices (e.g., chips, die, die planes, packages) or other discrete electrical devices, in electrical communication with one or more other components through electrical lines of a printed circuit board (PCB) or the like. Each of the functions and/or modules described herein, in certain embodiments, may be embodied by or implemented as a circuit.

Reference throughout this specification to "one embodiment," "an embodiment," or similar language means that a particular feature, structure, or characteristic described in connection with the embodiment is included in at least one embodiment of the present disclosure. Thus, appearances of the phrases "in one embodiment," "in an embodiment," and similar language throughout this specification may, but do not necessarily, all refer to the same embodiment, but mean "one or more but not all embodiments" unless expressly specified otherwise. The terms "including," "comprising," "having," and variations thereof mean "including but not limited to", unless expressly specified otherwise. An enumerated listing of items does not imply that any or all of the items are mutually exclusive and/or mutually inclusive, unless expressly specified otherwise. The terms "a," "an," and "the" also refer to "one or more" unless expressly specified otherwise.

Further, as used herein, reference to reading, writing, storing, buffering, and/or transferring data can include the entirety of the data, a portion of the data, a set of the data, and/or a subset of the data. Likewise, reference to reading, writing, storing, buffering, and/or transferring non-host data can include the entirety of the non-host data, a portion of the non-host data, a set of the non-host data, and/or a subset of the non-host data.

Lastly, the terms "or" and "and/or" as used herein are to be interpreted as inclusive or meaning any one or any combination. Therefore, "A, B or C" or "A, B and/or C" mean "any of the following: A; B; C; A and B; A and C; B and C; A, B and C." An exception to this definition will occur only when a combination of elements, functions, steps, or acts are in some way inherently mutually exclusive.

Aspects of the present disclosure are described below with reference to schematic flowchart diagrams and/ or schematic block diagrams of methods, apparatuses, systems, and computer program products according to embodiments of the disclosure. It will be understood that each block of the schematic flowchart diagrams and/or schematic block diagrams, and combinations of blocks in the schematic flowchart diagrams and/or schematic block diagrams, can be implemented by computer program instructions. These computer program instructions may be provided to a processor of a computer or other programmable data processing apparatus to produce a machine, such that the instructions, which execute via the processor or other programmable data processing apparatus, create means for implementing the functions and/or acts specified in the schematic flowchart diagrams and/or schematic block diagrams block or blocks.

It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. Other steps and methods may be conceived that are equivalent in function, logic, or effect to one or more blocks, or portions thereof, of the illustrated figures. Although various arrow types and line types may be employed in the flowchart and/or block diagrams, they are understood not to limit the scope of the corresponding embodiments. For instance, an arrow may indicate a waiting or monitoring period of unspecified duration between enumerated steps of the depicted embodiment.

In the following detailed description, reference is made to the accompanying drawings, which form a part thereof. The foregoing summary is illustrative only and is not intended to be in any way limiting. In addition to the illustrative aspects, embodiments, and features described above, further aspects, embodiments, and features will become apparent by reference to the drawings and the following detailed description. The description of elements in each figure may refer to elements of proceeding figures. Like numbers may refer to like elements in the figures, including alternate embodiments of like elements.

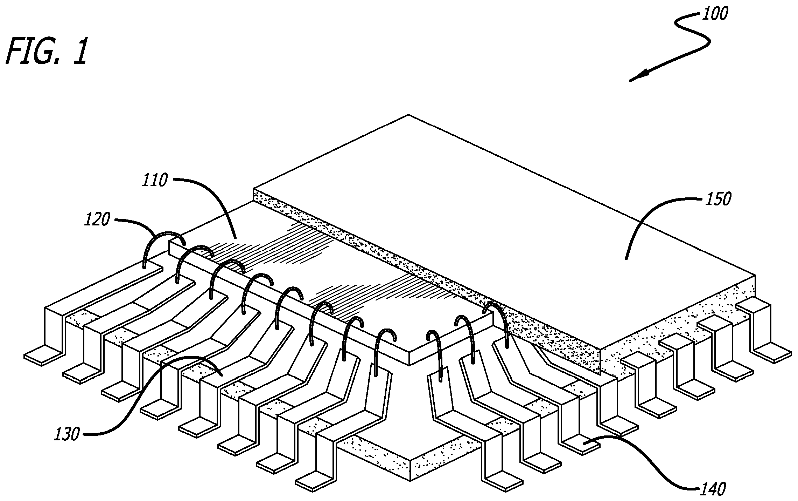

Referring to FIG. 1, a conceptual partial cutaway illustration of a processor 100 in accordance with various embodiments of the disclosure is shown. As those skilled in the art will recognize, the processor 100 comprises a die 110 that is also commonly known as an integrated circuit or "IC". The die 110 communicates via a series of pins 140 which extend out from a set of corresponding lead frames 130. The pins 140 are often connected to a substrate (not shown). In many embodiments, the lead frames 130 can be connected to the die 110 via a series of wires 120. Thus, a series of communication channels can be derived from the die 110, through a plurality of wires 120, through a series of lead frames 130 to a corresponding group of pins 140. In a number of embodiments, these components are often covered by a resin 150 which encapsulate and protect the components from damage.

In the context of processor communication, the utilization of these communication channels often involves the integration of one or more serializers and deserializers, collectively known as SerDes components. These are fundamental in facilitating the transmission of data over serial channels. When a processor generates parallel data that needs to be transmitted, the serializer converts this data into a serial stream. The communication channels, represented by physical structures like lead frames and pins, serve as pathways for the serialized data. These channels extend beyond the processor package to the substrate, or Printed Circuit Board (PCB), incorporating traces and conductive pathways for efficient data transmission.

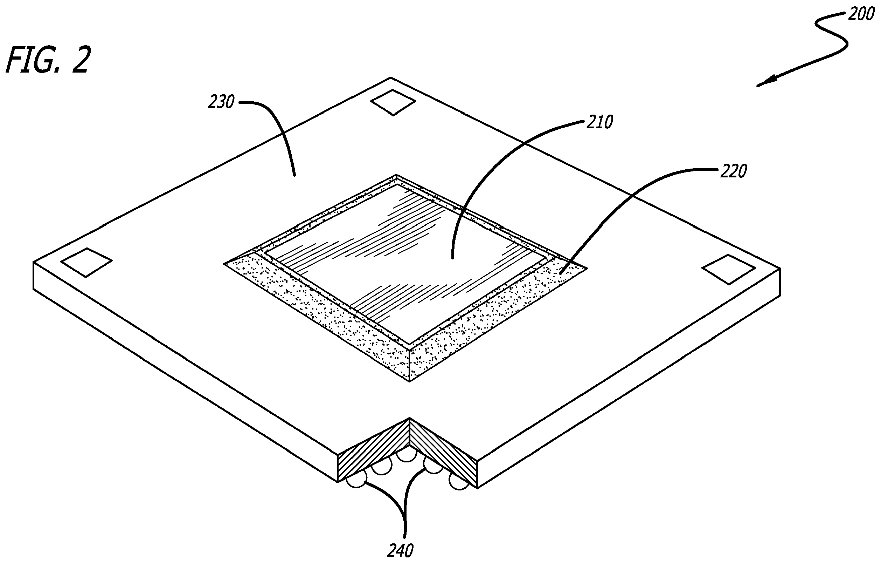

Although a specific embodiment for a conceptual partial cutaway illustration of a processor 100 suitable for carrying out the various steps, processes, methods, and operations described herein is discussed with respect to FIG. 1, any of a variety of systems and/or processes may be utilized in accordance with embodiments of the disclosure. For example, those skilled in the art will recognize that the exact layout, configuration, or design of the processor 100 can vary based on the application desired. The processor 100 depicted in FIG. 1 is provided for conceptual purposes and is not intended to be limiting to this specific configuration. The elements depicted in FIG. 1 may also be interchangeable with other elements of FIGS. 2 - 8 as required to realize a particularly desired embodiment.

Referring to FIG. 2, a conceptual partial cutaway illustration of a processing unit 200 in accordance with various embodiments of the disclosure is shown. In the embodiment depicted in FIG. 2, a die 210 is coupled to a substrate 230. In various embodiments, the processor can be covered with underfill 220. In further embodiments, the processing unit 200 may comprise a series of solder balls 240. As those skilled in the art will recognize, the solder balls 240 often form part of a ball grid array (BGA) configuration on the underside of the processing unit 200, which facilitate the connection between the processing unit 200 and a motherboard.

In a number of embodiments, semiconductor packaging can comprise the die 210, containing the integrated circuits, being securely mounted onto a substrate 230, which provides physical support and facilitates electrical connections. To address potential gaps and differences in thermal expansion between the die and the substrate, an underfill 220 is often applied. In certain embodiments, the die 210 can be attached to the substrate 230 using adhesives, and then an underfill 220, typically a liquid or gel-like material, is dispensed around the die's perimeter. This underfill 220 flows into the gaps through capillary action, creating a strong mechanical bond. After placement, the underfill is cured or hardened, forming a solid and stable connection between the die 210 and the substrate 230. Beyond improving mechanical integrity, the underfill 220 enhances thermal performance by serving as a thermal interface material, facilitating efficient heat transfer. Additionally, the underfill 220 provides protection for the die 210 and wire bonds against environmental factors like moisture and contaminants. The curing process can be achieved through methods such as heat or ultraviolet light, ensuring the reliability, durability, and optimal thermal characteristics of the final packaged semiconductor device.

Although a specific embodiment for a conceptual partial cutaway illustration of a processing package suitable for carrying out the various steps, processes, methods, and operations described herein is discussed with respect to FIG. 2, any of a variety of systems and/or processes may be utilized in accordance with embodiments of the disclosure. For example, the term "processing unit" is used herein to describe the coupled processor and substrate. However, those skilled in the art will recognize that a processing unit may be considered to be other configurations of processors, substrates, and other components. Similarly, some skilled in the art will term the processing unit 200 as simply a "processor", and the processor depicted in FIG. 1 as a CPU, or IC. It is contemplated that other terminology may be utilized, but herein we utilize processor and processing unit separately. The elements depicted in FIG. 2 may also be interchangeable with other elements of FIGS. 1 and 3 - 8 as required to realize a particularly desired embodiment.

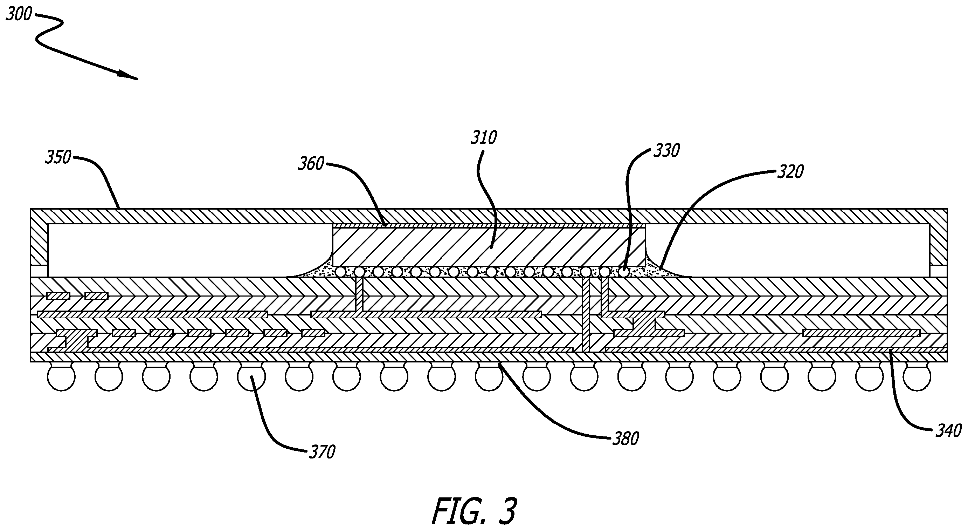

Referring to FIG. 3, a conceptual side-view illustration of a processing package 300 in accordance with various embodiments of the disclosure is shown. In the embodiment depicted in FIG. 3, the processing package 300 comprises a die 310 which is coupled to a substrate 340 via a series of pins 330 or other connections. In further embodiments, the processing package 300 comprises a plurality of solder balls 370 and eutectic solder 380. As those skilled in the art will recognize, solder balls generally refer to the physical components, while eutectic solder specifies the specific alloy composition chosen for its favorable melting properties during the soldering process, ensuring reliable and efficient bonding in semiconductor packaging.

In various embodiments, the processing package 300 is further defined by the application of a thermal grease 360 onto the processor/die 310. Additionally, a cap 350 can be fitted on top of the processing unit. The thermal grease 360 can be configured to allow for the thermal exchange or passing of heat generated by the die 310 to the cap 350 to better dissipate the generated heat. Thus, herein the processing package 300 can be understood as a processing unit with a cap applied.

Although a specific embodiment for a conceptual side-view illustration of a processing package suitable for carrying out the various steps, processes, methods, and operations described herein is discussed with respect to FIG. 3, any of a variety of systems and/or processes may be utilized in accordance with embodiments of the disclosure. For example, the terminology utilized herein can be understood as exemplary and it is understood that those skilled in the art may utilize different terminology for the various components described herein. The elements depicted in FIG. 3 may also be interchangeable with other elements of FIGS. 1 - 2 and 4 - 8 as required to realize a particularly desired embodiment.

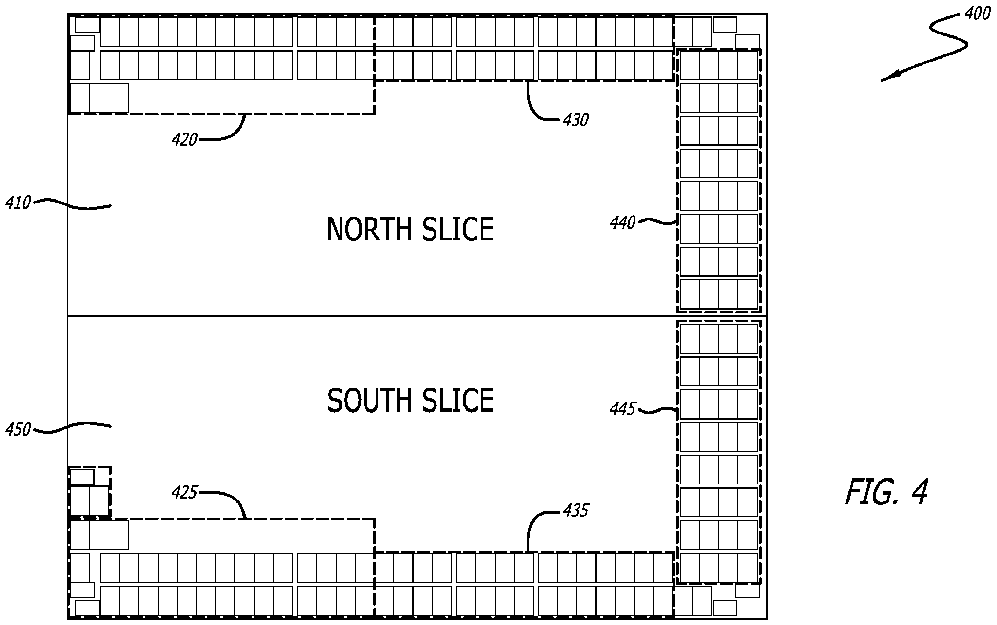

Referring to FIG. 4, a conceptual illustration of a bifurcated die 400 with two slices in accordance with various embodiments of the disclosure is shown. Often, a die is designed such that the entire surface area is utilized to maximize the space efficiencies. In modern processor designs, the dies may be configured with multiple cores, slices, or the like.

When a die is manufactured with multiple slices or cores, it is common for not all of them to function perfectly due to potential defects or variations in the fabrication process. In such cases, a technique known as "binning" is employed during the testing and validation phase. During manufacturing, processors are tested to identify any faulty or suboptimal cores. Once identified, the processor is categorized into different bins or groups based on the quality and performance of its cores. Processors with all functional cores intact are placed in the highest-performing bin and often sold as premium or high-end models. Processors with one or more non-functional cores are placed in lower-performance bins.

These dies with defective cores can still be used effectively by disabling the faulty cores of slices through a process called "disabling" or "harvesting." This involves configuring the die to only utilize the functional areas, effectively turning off the non-functional ones. The disabled areas are then bypassed during operation, and the processor operates with the remaining functional cores or slices. This approach allows semiconductor manufacturers to salvage imperfect chips and offer them at a lower price point, providing cost-effective solutions for consumers who may not need the full complement of slices or cores for their intended applications. Additionally, it helps minimize waste in the manufacturing process, contributing to overall production efficiency.

In the embodiment depicted in FIG. 4, the die 400 comprises a north slice 410 and a south slice 450. In some embodiments, the north slice 410 is configured with a plurality of SerDes channels. The SerDes channels can be configured into various groupings. In a number of embodiments, the first grouping 420 on the north slice 410 can have a corresponding first grouping 425 on the south slice 450. Likewise, a second grouping 430 of SerDes channels on the north slice 410 can have a corresponding second grouping 435 in the south slice 450. Finally, a third grouping 440 in the north slice 410 can have a corresponding third grouping 445 on the south slice 450. With this configuration, each slice can be configured with the same number of SerDes channels. In some embodiments, this may be done in a mirror type configuration, but it is not required. However, in various embodiments, having a similar configuration can allow for the utilization of either slice within a substrate coupling. Indeed, by utilizing such an arrangement, the trace lengths of the SerDes channels (or other similar communication channels) can be minimized, improving overall performance.

Although a specific embodiment for a conceptual illustration of a bifurcated die with two slices suitable for carrying out the various steps, processes, methods, and operations described herein is discussed with respect to FIG. 4, any of a variety of systems and/or processes may be utilized in accordance with embodiments of the disclosure. For example, the exact layout of the channels and corresponding channels may occur in any layout or fashion. The elements depicted in FIG. 4 may also be interchangeable with other elements of FIGS. 1 - 3 and 5 - 8 as required to realize a particularly desired embodiment.

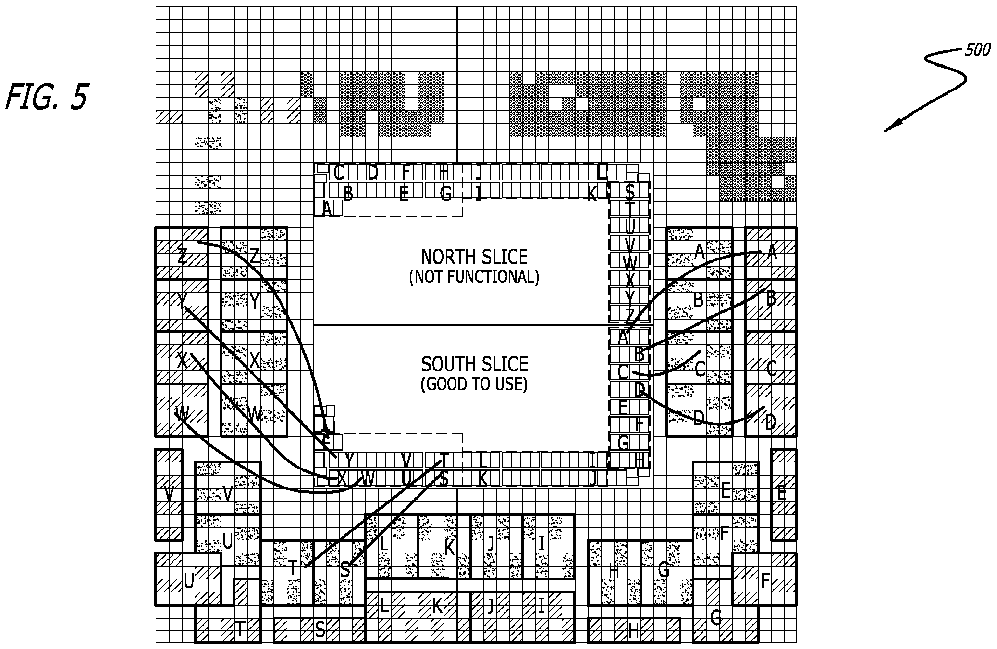

Referring to FIG. 5, a conceptual illustration of a rotatable die coupled with a substrate in a south slice rotation in accordance with various embodiments of the disclosure is shown. In many embodiments, the processing unit 500 can be configured in multiple ways. As described in more detail above, a die may include various cores, slices, or other areas that are functional and/or non-functional. In response to use cases where only a certain portion of the die is usable, the substrate can be configured to better utilize these arrangements. Traditionally, the substrate and trace arrangement therein would not change based on the coupling of the die to the substrate. However, in a number of embodiments described herein, the die can be rotated to seat the functional slice toward one side of the substrate.

In this way, it can be known that the functional area to be utilized within the die will always be on one portion of the processing unit 500. As a result, the substrate can be reconfigured to take advantage of this configuration. In the embodiment depicted in FIG. 5, the functional slice of the die comprises a plurality of SerDes channels (depicted as groupings denoted by letters of the alphabet) that have a plurality of corresponding SerDes channels (also depicted as groupings denoted by letters of the alphabet). The corresponding SerDes channels on the substrate can be arranged on three of the four sides surrounding the die. By compressing these groupings, it may allow for a shorter matching plurality of traces to be made within the substrate. This decreased trace length can correspond to a decrease in noise, insertion loss (often measured in dB), or the like. In some embodiments, this may even allow for the removal of re-timers and/or jumper cables on the system PCB, which can aid in cost savings during manufacture.

Although a specific embodiment for a conceptual illustration of a rotatable die coupled with a substrate in a south slice rotation suitable for carrying out the various steps, processes, methods, and operations described herein is discussed with respect to FIG. 5, any of a variety of systems and/or processes may be utilized in accordance with embodiments of the disclosure. For example, the specific layout, configuration, and/or location of the communication channels can vary depending on the application desired. Although a bifurcated die is shown, it is contemplated that other multi-slice arrangements can benefit from this type of compressed grouping configurations, allowing for the rotating of dies when coupled to the substrates. The elements depicted in FIG. 5 may also be interchangeable with other elements of FIGS. 1 - 4 and 6 - 8 as required to realize a particularly desired embodiment.

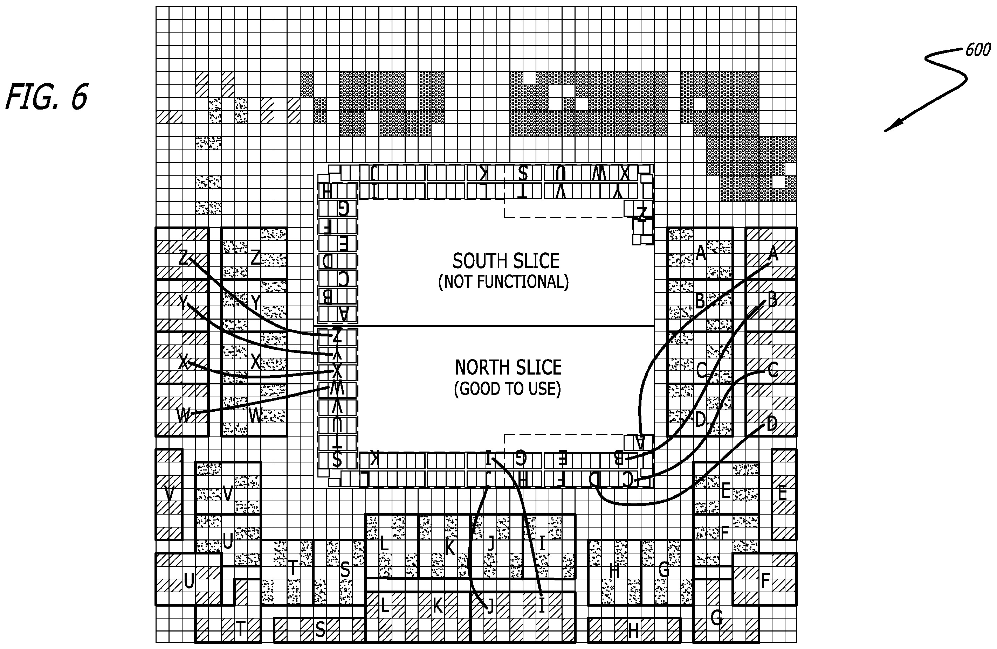

Referring to FIG. 6, a conceptual illustration of a rotatable die coupled with a substrate in a north slice rotation in accordance with various embodiments of the disclosure is shown. In the embodiment depicted in FIG. 6, the processing unit 600 has a similar substrate to the one depicted in FIG. 5, but the die is rotated one-hundred and eighty-degrees such that the north slice is now coupled toward the bottom of the substrate (relative to the depicted orientation). Similar to the discussion of FIG. 5, the north slice of this die is functional while the south slice is non-functional. As a result, the die is coupled to the substrate such that the north slice is closer to the plurality of corresponding SerDes channels. In the embodiment depicted in FIG. 6, the functional slice of the die comprises a plurality of SerDes channels (depicted as groupings denoted by letters of the alphabet) that have a plurality of corresponding SerDes channels (also depicted as groupings denoted by letters of the alphabet).

As can be seen in the embodiment depicted in FIG. 6, the plurality of SerDes channels on the die is in a different configuration than the arrangement shown in the embodiment of FIG. 5. However, the plurality of matching traces can be arranged such that they allow a communicative connection from the plurality of SerDes channels on the die to the plurality of corresponding SerDes channels on the substrate. As a result, the compression of SerDes channels on three of the four sides of the substrate surrounding the die can allow for shorter trace lengths, increasing overall performance and, in certain embodiments, reducing manufacturing costs as described above.

Although a specific embodiment for a conceptual illustration of a rotatable die coupled with a substrate in a north slice rotation suitable for carrying out the various steps, processes, methods, and operations described herein is discussed with respect to FIG. 6, any of a variety of systems and/or processes may be utilized in accordance with embodiments of the disclosure. For example, the traces may be configured in certain embodiments to be branched or otherwise routed to the different location of SerDes channels on the die, however the die may be configured such that the traces to the corresponding SerDes channels on the substrate can be the same. The elements depicted in FIG. 6 may also be interchangeable with other elements of FIGS. 1- 5 and 7 - 8 as required to realize a particularly desired embodiment.

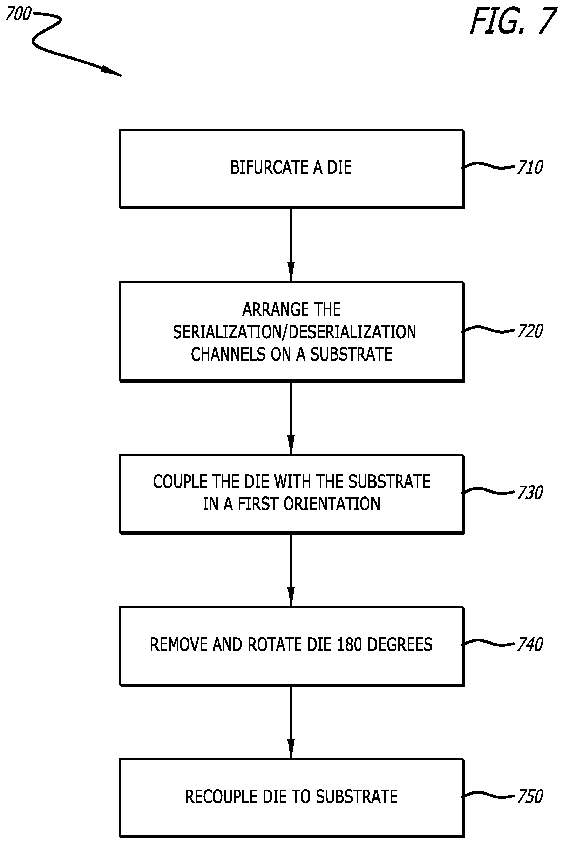

Referring to FIG. 7, a flowchart depicting a process 700 for coupling a bifurcated die in a substrate in multiple orientations in accordance with various embodiments of the disclosure is shown. In many embodiments, the process 700 can bifurcate a die (block 710). As discussed above, bifurcating a die can be a result of salvaging a slice or core(s) that are functional apart from those that are not. In this way, non-optimal dies can still be utilized in various applications. Often, dies will comprise a plurality of SerDes channels that can process various data to and from the die. As shown in the previous embodiments, the bifurcation can render the die into a first slice and a second slice. In additional embodiments, the layout of the SerDes channels between the first slice and second slice can be divided equally such that each slice comprises an equal number of SerDes channels.

In a number of embodiments, the process 700 can arrange the serialization/deserialization (SerDes) channels on a substrate (block 720). These SerDes channels on the substrate can correspond to the SerDes channels available on the die. As discussed above, various embodiments, may arrange the SerDes channels in a compressed or otherwise compact fashion, such as arranging them on one, two, or three sides of the substrate. In this way, the trace lengths needed to complete the SerDes channels can be reduced.

In more embodiments, the process 700 can couple the die with the substrate in a first orientation (block 730). As those skilled in the art will recognize, the coupling can be done during a manufacturing process where the die is seated or otherwise disposed on the substrate to complete a plurality of communication channels. The first orientation can be any suitable orientation to complete the communication channels between the die and the substrate. In some embodiments, a first orientation can be associated with a first slice of the die, while a second orientation can be associated with a second slice of the die.

In further embodiments, the process 700 can remove and rotate the die 180 degrees (block 740). In certain cases, a die may not be suitable for coupling at a first orientation. Thus, a new orientation may be needed, necessitating the die's removal from the substrate. In certain embodiments, the die may be bifurcated in a way that rotating the die one-hundred and eighty degrees can allow for the use of a different slice of the die. Specifically, in some embodiments, the first slice can be associated with a first orientation, and the second slice is associated with the second orientation, such that the first and second orientation are one-hundred eighty degrees relative to each other. In still more embodiments, the process 700 can recouple the substrate to the die (block 750). This recoupling can be done during the manufacturing process as well.

Although a specific embodiment for a process 700 for coupling a bifurcated die in a substrate in multiple orientations suitable for carrying out the various steps, processes, methods, and operations described herein is discussed with respect to FIG. 7, any of a variety of systems and/or processes may be utilized in accordance with embodiments of the disclosure. For example, the embodiment described herein discloses a coupling, removal, and recoupling method. However, some embodiments may determine the correct orientation or functional slice prior to coupling and require only a single coupling between the die and the substrate. The elements depicted in FIG. 7 may also be interchangeable with other elements of FIGS. 1 - 6 and 8 as required to realize a particularly desired embodiment.

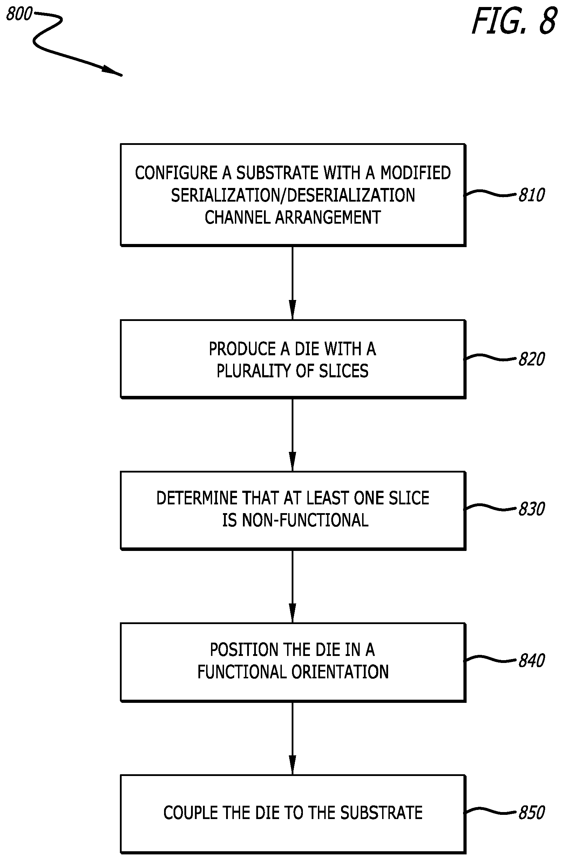

Referring to FIG. 8, a flowchart depicting a process 800 for configuring a substrate for use with a bifurcated die in accordance with various embodiments of the disclosure is shown. In many embodiments, the process 800 can configure a substrate with a modified serialization/deserialization (SerDes) channel arrangement (block 810). As described above, if the die is configured in a particular fashion, it may be coupled to the substrate such that the SerDes channels are always located toward one end of the die. In this way, configuring the substrate SerDes channels closer to that side can reduce trace lengths and increase overall performance while potentially reducing manufacturing costs. In various embodiments, the substrate can be configured to extend outward from the die on all four sides upon coupling and the corresponding SerDes channels on the substrate are disposed on three of the four sides.

In a number of embodiments, the process 800 can produce a die with a plurality of slices (block 820). The die can be configured with multiple slices or cores, wherein some may not be functional. To allow the continued use of these dies, the use of functional slices/cores may be utilized within other lower-cost products.

In some embodiments, the process 800 can determine that at least one slice is non-functional (block 830). This determination can be from running one or more tests after manufacturing the die. In certain embodiments, the functionality can be determined upon coupling the die with a substrate.

In further embodiments, the process 800 can position the die in a functional orientation (block 840). As discussed above, the substrate can be configured to allow functionality to one or more slice of the die. In order to facilitate this, the die can be positioned in an orientation that allows coupling such that the functional slice can be utilized and in communication with the substrate.

In more embodiments, the process 800 can couple the die to the substrate (block 850). The coupling can be done during the manufacturing process. Upon coupling the die in a certain position upon the reconfigured substrate, a plurality of SerDes and/or other communication channels can be completed such that the components within the die can be communicatively coupled with external components.

Although a specific embodiment for a process 800 for configuring a substrate for use with a bifurcated die suitable for carrying out the various steps, processes, methods, and operations described herein is discussed with respect to FIG. 8, any of a variety of systems and/or processes may be utilized in accordance with embodiments of the disclosure. For example, the substrate can be configured to allow for various orientations of the die to be suitable for normal operation and completion of the SerDes and other communication channels. The elements depicted in FIG. 8 may also be interchangeable with other elements of FIGS. 1 - 7 as required to realize a particularly desired embodiment.

In summary, devices, systems, methods, and processes are described for allowing for the orientation of a die within a processing unit to be rotated while still maintaining suitable communication channels. During manufacturing, dies may be configured into multiple slices. Some of these slices may end up becoming non-functional due to a defect or other condition. However, a remaining functional slice may still be utilized and coupled to a substrate. The die can be configured such that the communication channels are available on one specific section of the die, even if it is rotated. Likewise, the substrate can also be configured to compress the location of the corresponding communication channels into a smaller area closer to that specific section. In this way, shorter trace lines can be made increasing performance and reducing manufacturing costs. Thus, the die can be rotated depending on which slice is functional, and still be suitable for coupling to the substrate.

Although the present disclosure has been described in certain specific aspects, many additional modifications and variations would be apparent to those skilled in the art. In particular, any of the various processes described above can be performed in alternative sequences and/or in parallel (on the same or on different computing devices) in order to achieve similar results in a manner that is more appropriate to the requirements of a specific application. It is therefore to be understood that the present disclosure can be practiced other than specifically described without departing from the scope and spirit of the present disclosure. Thus, embodiments of the present disclosure should be considered in all respects as illustrative and not restrictive. It will be evident to the person skilled in the art to freely combine several or all of the embodiments discussed here as deemed suitable for a specific application of the disclosure. Throughout this disclosure, terms like "advantageous", "exemplary" or "example" indicate elements or dimensions which are particularly suitable (but not essential) to the disclosure or an embodiment thereof and may be modified wherever deemed suitable by the skilled person, except where expressly required. Accordingly, the scope of the disclosure should be determined not by the embodiments illustrated, but by the appended claims and their equivalents.

Any reference to an element being made in the singular is not intended to mean "one and only one" unless explicitly so stated, but rather "one or more." All structural and functional equivalents to the elements of the above-described preferred embodiment and additional embodiments as regarded by those of ordinary skill in the art are hereby expressly incorporated by reference and are intended to be encompassed by the present claims.

## Claims

1. A processing unit (200, 500, 600), comprising:
a die (400), wherein the die is bifurcated, wherein the bifurcation is configured to render the die into a first slice (410) and a second slice (450); and
a substrate (230, 340), configured to couple with the die at a first orientation,
wherein the substrate is further configured to couple with the die at a second orientation,
wherein the first slice and second slice have similar communication channels.

2. The processing unit (200, 500, 600) of claim 1, wherein the second orientation is one-hundred and eighty degrees relative to the first orientation.

3. The processing unit (200, 500, 600) of claim 1 or 2, wherein the communication channels include a plurality of serialization/deserialization, SerDes, channels.

4. The processing unit (200, 500, 600) of claim 3, wherein the plurality of SerDes channels are divided equally between the first slice and the second slice.

5. The processing unit (200, 500, 600) of claim 4, wherein the substrate is configured with a plurality of corresponding SerDes channels.

6. The processing unit (200, 500, 600) of claim 5, wherein the substrate extends outward from the die on all four sides when coupled.

7. The processing unit (200, 500, 600) of claim 6, wherein the plurality of corresponding SerDes channels on the substrate are disposed on three of the four sides.

8. The processing unit (200, 500, 600) of claim 7, wherein the corresponding SerDes channels are communicatively coupled to the plurality of SerDes channels on the substrate through a matching plurality of traces.

9. The processing unit (200, 500, 600) of claim 8, wherein the corresponding plurality of SerDes channels on the substrate are arranged to facilitate shorter trace lengths of the matching plurality of traces.

10. A method (700, 800), comprising:
bifurcating (710) a die into a first slice (410) and a second slice (450), wherein the first slice and second slice have similar communication channels;
configuring (800) a substrate to couple with the die at both a first orientation associated with a first slice, and a second orientation associated with the second slice; and
coupling (700) the die to the substrate.

11. The method (700, 800) of claim 10, wherein each slice of the die is configured with a plurality of serialization/deserialization, SerDes, channels.

12. The method (700, 800) of claim 11, wherein the substrate is further configured with a corresponding plurality of SerDes channels.

13. The method (700, 800) of claim 12, wherein the substrate extends outward from the die on all four sides when coupled, optionally wherein the plurality of corresponding SerDes channels on the substrate are disposed on three of the four sides.

14. The method (700, 800) of claim 13, wherein the corresponding SerDes channels are communicatively coupled to the plurality of SerDes channels on the substrate through a matching plurality of traces, optionally wherein the corresponding plurality of SerDes channels on the substrate are arranged to facilitate shorter trace lengths of the matching plurality of traces.

15. The processing unit (200, 500, 600) of any of claims 1 to 9,
wherein the die (400) is:
bifurcated into the first slice (410) and the second slice (450); and
configured with a plurality of similar serialization/deserialization, SerDes, channels on each slice; and
wherein the substrate (230, 340) is configured to communicatively couple with the plurality of SerDes channels via a corresponding plurality of SerDes channels and a matching plurality of traces;
wherein each orientation provide similar communicative coupling between the plurality of SerDes channels on each slice and the corresponding SerDes channels and matching plurality of traces on the substrate.

## Patentansprüche

1. Verarbeitungseinheit (200, 500, 600), umfassend:
eine Matrize (400), wobei die Matrize zweigeteilt ist, wobei die Zweiteilung dazu konfiguriert ist, die Matrize in einen ersten Abschnitt (410) und einen zweiten Abschnitt (450) zu unterteilen; und
ein Substrat (230, 340), das dazu konfiguriert ist, in einer ersten Orientierung mit der Matrize gekoppelt zu werden,
wobei das Substrat ferner dazu konfiguriert ist, in einer zweiten Orientierung mit der Matrize gekoppelt zu werden,
wobei der erste Abschnitt und der zweite Abschnitt ähnliche Kommunikationskanäle aufweisen.

2. Verarbeitungseinheit (200, 500, 600) nach Anspruch 1, wobei die zweite Orientierung bezüglich der ersten Orientierung um einhundertachtzig Grad gedreht ist.

3. Verarbeitungseinheit (200, 500, 600) nach Anspruch 1 oder 2, wobei die Kommunikationskanäle eine Vielzahl von Serialisierungs-/Deserialisierungs-, SerDes-, Kanälen enthalten.

4. Verarbeitungseinheit (200, 500, 600) nach Anspruch 3, wobei die Vielzahl von SerDes-Kanälen gleichmäßig zwischen dem ersten Abschnitt und dem zweiten Abschnitt aufgeteilt ist.

5. Verarbeitungseinheit (200, 500, 600) nach Anspruch 4, wobei das Substrat mit einer Vielzahl von entsprechenden SerDes-Kanälen konfiguriert ist.

6. Verarbeitungseinheit (200, 500, 600) nach Anspruch 5, wobei sich das Substrat, wenn es gekoppelt ist, an allen vier Seiten von der Matrize nach außen erstreckt.

7. Verarbeitungseinheit (200, 500, 600) nach Anspruch 6, wobei die Vielzahl von entsprechenden SerDes-Kanälen auf dem Substrat an drei der vier Seiten angeordnet ist.

8. Verarbeitungseinheit (200, 500, 600) nach Anspruch 7, wobei die entsprechenden SerDes-Kanäle über eine passende Vielzahl von Leiterbahnen mit der Vielzahl von SerDes-Kanälen auf dem Substrat kommunikativ gekoppelt sind.

9. Verarbeitungseinheit (200, 500, 600) nach Anspruch 8, wobei die entsprechende Vielzahl von SerDes-Kanälen auf dem Substrat angeordnet ist, um kürzere Leiterbahnlängen der passenden Vielzahl von Leiterbahnen zu ermöglichen.

10. Verfahren (700, 800), umfassend:
Zweiteilen (710) einer Matrize in einen ersten Abschnitt (410) und einen zweiten Abschnitt (450), wobei der erste Abschnitt und der zweite Abschnitt ähnliche Kommunikationskanäle aufweisen;
Konfigurieren (800) eines Substrats, damit es sowohl in einer ersten Orientierung, die einem ersten Abschnitt zugeordnet ist, als auch in einer zweiten Orientierung, die dem zweiten Abschnitt zugeordnet ist, mit der Matrize gekoppelt wird; und
Koppeln (700) der Matrize mit dem Substrat.

11. Verfahren (700, 800) nach Anspruch 10, wobei jeder Abschnitt der Matrize mit einer Vielzahl von Serialisierungs-/Deserialisierungs-, SerDes-, Kanälen konfiguriert ist.

12. Verfahren (700, 800) nach Anspruch 11, wobei das Substrat ferner mit einer entsprechenden Vielzahl von SerDes-Kanälen konfiguriert ist.

13. Verfahren (700, 800) nach Anspruch 12, wobei sich das Substrat, wenn es gekoppelt ist, an allen vier Seiten von der Matrize nach außen erstreckt, wobei optional eine Vielzahl von entsprechenden SerDes-Kanälen auf dem Substrat an drei der vier Seiten angeordnet ist.

14. Verfahren (700, 800) nach Anspruch 13, wobei die entsprechenden SerDes-Kanäle über eine passende Vielzahl von Leiterbahnen mit der Vielzahl von SerDes-Kanälen auf dem Substrat kommunikativ gekoppelt sind, wobei optional die entsprechende Vielzahl von SerDes-Kanälen auf dem Substrat angeordnet ist, um kürzere Leiterbahnlängen der passenden Vielzahl von Leiterbahnen zu ermöglichen.

15. Verarbeitungseinheit (200, 500, 600) nach einem der Ansprüche 1 bis 9,
wobei die Matrize (400):
in einen ersten Abschnitt (410) und einen zweiten Abschnitt (450) aufgeteilt ist; und
mit einer Vielzahl ähnlicher Serialisierungs-/Deserialisierungs-, SerDes-, Kanälen auf jedem Abschnitt konfiguriert ist; und
wobei das Substrat (230, 340) dazu konfiguriert ist, sich über eine entsprechende Vielzahl von SerDes-Kanälen und eine passende Vielzahl von Leiterbahnen kommunikativ mit der Vielzahl von SerDes-Kanälen zu koppeln;
wobei jede Orientierung eine ähnliche kommunikative Kopplung zwischen der Vielzahl von SerDes-Kanälen auf jedem Abschnitt und den entsprechenden SerDes-Kanälen und der passenden Vielzahl von Leiterbahnen auf dem Substrat bereitstellt.

## Revendications

1. Unité de traitement (200, 500, 600), comprenant :
une pastille (400), dans laquelle la pastille est divisée en deux, dans laquelle la division est configurée pour faire la pastille en une première tranche (410) et une seconde tranche (450) ; et
un substrat (230, 340), configuré pour s'accoupler avec la pastille selon une première orientation,
dans laquelle le substrat est en outre configuré pour s'accoupler avec la pastille selon une seconde orientation,
dans laquelle la première tranche et la seconde tranche présentent des canaux de communication similaires.

2. Unité de traitement (200, 500, 600) selon la revendication 1, dans laquelle la seconde orientation est à cent quatre-vingts degrés par rapport à la première orientation.

3. Unité de traitement (200, 500, 600) selon la revendication 1 ou 2, dans laquelle les canaux de communication comportent une pluralité de canaux de sérialisation/désérialisation, SerDes.

4. Unité de traitement (200, 500, 600) selon la revendication 3, dans laquelle les canaux de la pluralité de canaux SerDes sont divisés de manière égale entre la première tranche et la seconde tranche.

5. Unité de traitement (200, 500, 600) selon la revendication 4, dans laquelle le substrat est configuré avec une pluralité de canaux SerDes correspondants.

6. Unité de traitement (200, 500, 600) selon la revendication 5, dans laquelle le substrat s'étend vers l'extérieur à partir de la pastille sur les quatre côtés une fois accouplé.

7. Unité de traitement (200, 500, 600) selon la revendication 6, dans laquelle la pluralité de canaux SerDes correspondants sur le substrat est disposée sur trois des quatre côtés.

8. Unité de traitement (200, 500, 600) selon la revendication 7, dans laquelle les canaux SerDes correspondants sont couplés en communication avec la pluralité de canaux SerDes sur le substrat par l'intermédiaire d'une pluralité correspondante de traces.

9. Unité de traitement (200, 500, 600) selon la revendication 8, dans laquelle la pluralité correspondante de canaux SerDes sur le substrat est agencée pour permettre des longueurs de traces plus courtes de la pluralité correspondante de traces.

10. Procédé (700, 800), comprenant :
la division (710) d'une pastille en une première tranche (410) et une seconde tranche (450), dans lequel la première tranche et la seconde tranche présentent des canaux de communication similaires ;
la configuration (800) d'un substrat à accoupler avec la pastille à la fois selon une première orientation associée à une première tranche, et selon une seconde orientation associée à la seconde tranche ; et
l'accouplement (700) de la pastille au substrat.

11. Procédé (700, 800) selon la revendication 10, dans lequel chaque tranche de la pastille est configurée avec une pluralité de canaux de sérialisation/désérialisation, SerDes.

12. Procédé (700, 800) selon la revendication 11, dans lequel le substrat est en outre configuré avec une pluralité correspondante de canaux SerDes.

13. Procédé (700, 800) selon la revendication 12, dans lequel le substrat s'étend vers l'extérieur à partir de la pastille sur les quatre côtés une fois accouplé, éventuellement dans lequel la pluralité de canaux SerDes correspondants sur le substrat est disposée sur trois des quatre côtés.

14. Procédé (700, 800) selon la revendication 13, dans lequel les canaux SerDes correspondants sont couplés en communication avec la pluralité de canaux SerDes sur le substrat par l'intermédiaire d'une pluralité correspondante de traces, éventuellement dans lequel la pluralité correspondante de canaux SerDes sur le substrat est agencée pour permettre des longueurs de trace plus courtes de la pluralité correspondante de traces.

15. Unité de traitement (200, 500, 600) selon l'une quelconque des revendications 1 à 9,
dans laquelle la pastille (400) est :
divisée en la première tranche (410) et la seconde tranche (450) ; et
configurée avec une pluralité de canaux de sérialisation/désérialisation, SerDes, similaires sur chaque tranche ; et
dans laquelle le substrat (230, 340) est configuré pour se coupler en communication avec la pluralité de canaux SerDes par le biais d'une pluralité correspondante de canaux SerDes et d'une pluralité correspondante de traces ;
dans lequel chaque orientation fournit un couplage en communication similaire entre la pluralité de canaux SerDes sur chaque tranche et les canaux SerDes correspondants et la pluralité correspondante de traces sur le substrat.
